(19) Europäisches Patentamt
European Patent Office
Office européen des brevets

(11) **EP 2 752 984 B1**

(12) **EUROPEAN PATENT SPECIFICATION**

(45) Date of publication and mention of the grant of the patent:
**15.11.2017  Bulletin 2017/46**

(21) Application number: **12828286.0**

(22) Date of filing: **28.08.2012**

(51) Int Cl.:
*H01L 37/02* *(2006.01)*    *F01N 5/02* *(2006.01)*

(86) International application number:
**PCT/JP2012/071713**

(87) International publication number:
**WO 2013/031775 (07.03.2013 Gazette 2013/10)**

(54) **POWER GENERATION SYSTEM**

STROMERZEUGUNGSSYSTEM

SYSTÈME DE GÉNÉRATION DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2011  JP 2011189971
31.08.2011  JP 2011189970**

(43) Date of publication of application:
**09.07.2014  Bulletin 2014/28**

(73) Proprietors:
• **Daihatsu Motor Co., Ltd.
Ikeda-shi, Osaka 563-8651 (JP)**
• **National University Corporation
Nagaoka University of Technology
Nagaoka
Niigata 940-2188 (JP)**

(72) Inventors:
• **KIM, Yoonho
Gamo-gun
Shiga 520-2593 (JP)**
• **SERIZAWA, Takeshi
Gamo-gun
Shiga 520-2593 (JP)**
• **TANAKA, Hirohisa
Gamo-gun
Shiga 520-2593 (JP)**
• **NAKAYAMA, Tadachika
Nagaoka-shi
Niigata 940-2188 (JP)**
• **TAKEDA, Masatoshi
Nagaoka-shi
Niigata 940-2188 (JP)**

• **YAMADA, Noboru
Nagaoka-shi
Niigata 940-2188 (JP)**
• **NIIHARA, Koichi
Nagaoka-shi
Niigata 940-2188 (JP)**
• **OGAWA, Kyohei
Nagaoka-shi
Niigata 940-2188 (JP)**
• **NAKATA, Hiroya
Nagaoka-shi
Niigata 940-2188 (JP)**
• **SHIDA, Masashi
Nagaoka-shi
Niigata 940-2188 (JP)**
• **ISHIZAWA, Satoshi
Nagaoka-shi
Niigata 940-2188 (JP)**

(74) Representative: **Schwabe - Sandmair - Marx
Patentanwälte Rechtsanwalt
Partnerschaft mbB
Joseph-Wild-Straße 20
81829 München (DE)**

(56) References cited:
DE-A1-102009 016 209    DE-C1- 3 938 890
JP-A- H11 332 266    JP-A- 2007 288 923
JP-A- 2008 156 201    US-A- 3 073 974
US-A- 3 149 246    US-A1- 2004 251 690
US-A1- 2006 102 224    US-A1- 2010 289 377

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

• KANDILIAN R ET AL: "The pyroelectric energy harvesting capabilities of PMN-PT near the morphotropic phase boundary", SMART MATERIALS AND STRUCTURES, vol. 20, no. 5, 19 April 2011 (2011-04-19) , pages 055020/1-10, XP020190405, ISSN: 0964-1726, DOI: 10.1088/0964-1726/20/5/055020

**Description**

TECHNICAL FIELD

The present invention relates to a power-generating system.

BACKGROUND ART

Conventionally, a large amount of heat energy is released and lost as, for example, waste heat, light, etc. in various energy-using devices such as internal combustion engines including an automobile engine; heat exchangers including a boiler and air-conditioning equipment; motor generators including a power generator and a motor; and luminous devices including lightings.

Nowadays, recovery and recycling of released heat energy as an energy source has been required in view of energy conservation, and as such a method, a pyroelectric generation in which a pyroelectric element is used is known.

To be specific, for example, Patent Document 1 below has proposed a method using a power-generating apparatus including a heat source that allows the temperatures of the plurality of pyroelectric elements to increase; a cooling source that allows the temperatures of the pyroelectric elements to decrease; and a moving unit that moves the heat source and the cooling source, and/or the pyroelectric elements, and by increasing and decreasing the temperature of the pyroelectric elements by the heat source and cooling source periodically, direct-current power or alternating-current power is taken out from the pyroelectric element. Power generation by thermally cycling a pyroelectric element a few °C above and/or below its Curie temperature is known from Patent Documents 2 and 3, as well as Non-Patent Document 1. Patent Document 4 suggests to arrange a pyroelectric generator at an exhaust pipe of an automobile engine.

Citation List

     Patent Document 1
     Japanese Unexamined Patent Publication No. H11-332266
     Patent Document 2: US 3,149,246
     Patent Document 3: US 2010/289377 A1
     Patent Document 4: US 2004/251690 A1

Non-Patent Document 1: Kandilian et al, Smart Materials and Structures 20 (2011), 055020

SUMMARY OF THE INVENTION

PROBLEM TO BE SOLVED BY THE INVENTION

Meanwhile, such a power-generating method requires power generation with more excellent efficiency.

An object of the present invention is to provide a power-generating system capable of more excellently efficient generation of electricity.

MEANS FOR SOLVING THE PROBLEM

To achieve the above object, a power-generating system of the present invention includes a heat source which is able to produce temporal temperature variation; a first device which is able to produce temporal temperature variation so as to include at least partially a temperature range of -20°C relative to the Curie temperature to +10°C relative to the Curie temperature based on the temperature change of the heat source, and in which polarization occurs; and a second device for taking out a net generating power from the first device according to claim 1.

In the power-generating system of the present invention, it is preferable that the first device changes its temperature so as to include its Curie temperature.

The first device may include a matrix that is capable of polarization and a dispersion material having a specific heat capacity that is lower than the specific heat capacity of the matrix, in which polarization occurs based on the temperature change of the heat source.

EFFECTS OF THE INVENTION

With the power-generating system of the present invention, power generation efficiency can be improved.

BRIEF DESCRIPTION OF THE DRAWINGS

     FIG. 1 is a schematic diagram illustrating the configuration of an embodiment of a power-generating system of the present invention.
     FIG. 2 is a schematic diagram illustrating the configuration of an embodiment of the first device shown in FIG. 1.
     FIG. 3 is a schematic diagram illustrating the configuration of another embodiment of the first device shown in FIG. 1.
     FIG. 4 is a schematic diagram illustrating the configuration of an embodiment of the power-generating system of the present invention on board.
     FIG. 5 is an enlarged view of a relevant part of the power-generating system shown in FIG. 4.
     FIG. 6 is a graph illustrating the relationship between the generated voltage and the temperature change in Example 1 and Comparative Example 1.
     FIG. 7 is a graph illustrating the relationship between the generated voltage and the temperature change in Example 2 and Example 3.
     FIG. 8 is a graph illustrating the relationship between the generated voltage and the temperature change in Example 4.

FIG. 9 is a graph illustrating the relationship between the generated voltage and the temperature change in Example 5.

FIG. 10 is a graph illustrating the relationship between the generated voltage and the temperature change in Comparative Example 2.

## EMBODIMENT OF THE INVENTION

### <First Embodiment>

In the following, a first embodiment of the present invention is described.

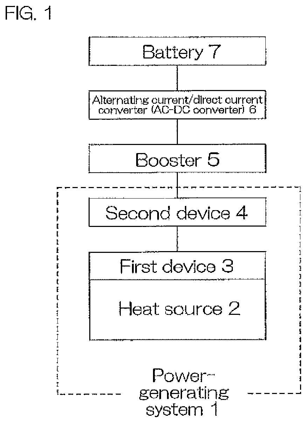

FIG. 1 is a schematic diagram illustrating the configuration of an embodiment (First Embodiment) of the power-generating system of the present invention.

In FIG. 1, a power-generating system 1 includes a heat source 2 having a temporal temperature variation; a first device 3 that undergoes polarization due to a temperature change of the heat source 2; and a second device 4 that takes out a net generating power from the first device 3.

The heat source 2 is an exhaust pipe of an internal combustion engine.

The internal combustion engine is, for example, a device that outputs motive power for vehicles. For example, a single cylinder or a multicylinder type is used, and in the single cylinder or multicylinder, a multi-stroke cycle (e.g., two-stroke cycle, four-stroke cycle, and six-stroke cycle, etc.) is used.

In such an internal combustion engine, pistons repeatedly move up and down in the cylinders, and such up-down moves of the pistons allow, for example, in the four-stroke cycle system, performance of an intake stroke, a compression stroke, a power stroke, and an exhaust stroke sequentially, and combustion of fuel, to output motive power.

In such an internal combustion engine, in the exhaust stroke, a high temperature exhaust gas is discharged via the exhaust gas pipe. At that time, the exhaust gas pipe receives the heat energy of the exhaust gas, increasing the temperature.

Meanwhile, in other strokes (strokes excluding the exhaust stroke), the exhaust gas amount in the exhaust gas pipe decreases, and therefore the heat energy received by the exhaust gas pipe decreases. As a result, the temperature of the exhaust gas pipe decreases.

Thus, the temperature of the internal combustion engine increases in the exhaust stroke, decreases in the intake stroke, compression stroke, and power stroke: that is, the temporal temperature variation is produced.

In particular, the above-described strokes are repeated periodically and sequentially in accordance with the piston cycle, and therefore the temperature of the exhaust gas pipes of the cylinders of the internal combustion engine changes periodically in accordance with the cycle of the repetition of the above-described strokes, to be more specific, a high-temperature state and a low-temperature state are repeated periodically.

The first device 3 is a device that undergoes polarization in accordance with the temperature change of the heat source 2.

The polarization here is defined as the following: a phenomenon of electromotive force occurrence in a material, including, for example, a phenomenon of occurrence of a potential difference by dielectric polarization due to displacement of plus and minus ions based on the deformation of a crystal, such as the piezoelectric effect; and/or a phenomenon of occurrence of a potential difference by changes in the dielectric constant due to a temperature change, such as the pyroelectric effect; and/or a phenomenon of occurrence of a potential difference by partial electric charge due to a temperature change or a temperature gradient, such as the Seebeck effect.

Examples of the first device 3 include, to be more specific, a device that undergoes polarization by the piezoelectric effect, a device that undergoes polarization by the pyroelectric effect, and a device that undergoes polarization by the Seebeck effect.

In the piezoelectric effect (phenomenon), when a pressure or a deformation is applied, polarization is caused in accordance with the degree of the pressure or the deformation.

The first device 3 that undergoes polarization by the piezoelectric effect is not particularly limited, and a thin, or bulk known piezoelectric element may be used. The description below regarding the piezoelectric element also applies to the piezo-based composite element described later.

When a piezoelectric element is used as the first device 3, the piezoelectric element is disposed, for example, so that the piezoelectric element is brought in the proximity of the heat source 2, or into contact with the heat source 2 with the electrode to be described later interposed therebetween while the surrounding thereof is fixed by a fixing member to suppress the volume expansion thereof. The fixing member is not particularly limited, and for example, the second device 4 (e.g., electrode, etc.) to be described later may also be used.

In this case, the piezoelectric element is heated or cooled by the temperature change over time of the heat source 2, which allows expansion or shrinkage thereof.

In such a case, the volume expansion of the piezoelectric element is suppressed by the fixing member, and therefore the piezoelectric element is pressed by the fixing member, which allows polarization to occur by the piezoelectric effect or phase transformation near the Curie temperature. In this manner, although to be described later, a net generating power is taken out from the thermoelectric element via the second device 4.

In such a piezoelectric element, usually, a heated state or a cooled state is kept, and when its temperature becomes constant (that is, the volume is constant), the polarization is neutralized, and by cooling or heating thereafter, the piezoelectric element undergoes polarization again.

Thus, as described above, when the temperature of the heat source 2 changes periodically, and a high-temperature state and a low-temperature state are periodically repeated, the piezoelectric element is heated and cooled repeatedly and periodically, and therefore polarization and neutralization of the piezoelectric element are periodically repeated.

As a result, a net generating power can be taken out as a periodically changing waveform (e.g., alternating current, pulsating current, etc.) by the second device 4 to be described later.

The pyroelectric effect is, for example, the effects (phenomenon) such as the following: when an insulator (dielectric) is heated or cooled, the insulator undergoes polarization in accordance with the temperature change. The pyroelectric effect includes a first effect and a second effect.

In the first effect, at the time of heating or cooling of the insulator, spontaneous polarization occurs by the temperature change, and an electric charge is generated on the insulator surface.

In the second effect, at the time of heating or cooling of the insulator, pressure deflection is caused in the crystal structure by the temperature change, and the pressure or the deformation on the crystal structure causes piezoelectric polarization (piezoelectric effect).

Such a device that undergoes polarization by the pyroelectric effect is not particularly limited, and a known pyroelectric element may be used. The description below regarding the pyroelectric element also applies to the pyroelectric-based composite element described later.

When a pyroelectric element is used as the first device 3, the pyroelectric element is disposed, for example, in the proximity of the heat source 2, or so as to be in contact with the heat source 2 with an electrode to be described later interposed therebetween.

In such a case, the pyroelectric element is heated or cooled by temperature changes over time of the heat source 2, and undergoes polarization by its pyroelectric effect (including the first effect and second effect). In this manner, although to be described later, a net generating power is taken out from the pyroelectric element via the second device 4.

In such a pyroelectric element, usually, a heated state or a cooled state is kept, and when its temperature becomes constant, the polarization is neutralized, and by cooling or heating thereafter, the pyroelectric element undergoes polarization again.

Thus, as described above, when the temperature of the heat source 2 changes periodically, and a high-temperature state and a low-temperature state are periodically repeated, the pyroelectric element is heated and cooled periodically and repeatedly, and therefore the polarization and neutralization of the pyroelectric element are periodically repeated.

As a result, a net generating power can be taken out as a periodically changing waveform (e.g., alternating current, pulsating current, etc.) by the second device 4 to be described later.

The Seebeck effect is, for example, the effect (phenomenon) such as the following: when a temperature difference is generated at both ends of a metal or a semiconductor, an electromotive force is generated in the metal or the semiconductor in accordance with the temperature difference.

The device that undergoes polarization by the Seebeck effect is not particularly limited, and a known thermoelectric element may be used. The description below regarding the thermoelectric element also applies to the thermoelectric-based composite element described later.

When a thermoelectric element is used as the first device 3, the thermoelectric element is disposed, for example, so that one end portion thereof is brought in the proximity of the heat source 2, or into contact with the heat source 2 with the electrode to be described later interposed therebetween, and the other end portion thereof is distant from the heat source 2.

In this case, only one end portion of the thermoelectric element is heated or cooled by the temperature change over time of the heat source 2, and a temperature difference is caused between the both ends (between one end portion and the other end portion thereof) of the thermoelectric element. At this time, an electromotive force is generated in the thermoelectric element by the Seebeck effect. In this manner, although to be described later, a net generating power is taken out from the thermoelectric element via the second device 4.

In such a thermoelectric element, when the temperature difference between the both ends is large, the electromotive force is high, which allows for obtainment of a high net generating power. On the other hand, when the temperature difference is small, the electromotive force is small, which decreases the net generating power to be taken out.

Thus, as described above, when the temperature of the heat source 2 changes periodically, and a high-temperature state and a low-temperature state are periodically repeated, the temperature of the one end portion of the thermoelectric element increases or decreases repeatedly and periodically, and therefore the degree of the electromotive force increases or decreases periodically in accordance with the temperature change.

As a result, a net generating power can be taken out as a periodically changing waveform (e.g., alternating current, pulsating current, etc.) by the second device 4 to be described later.

These first devices 3 may be used singly or in combination of two or more.

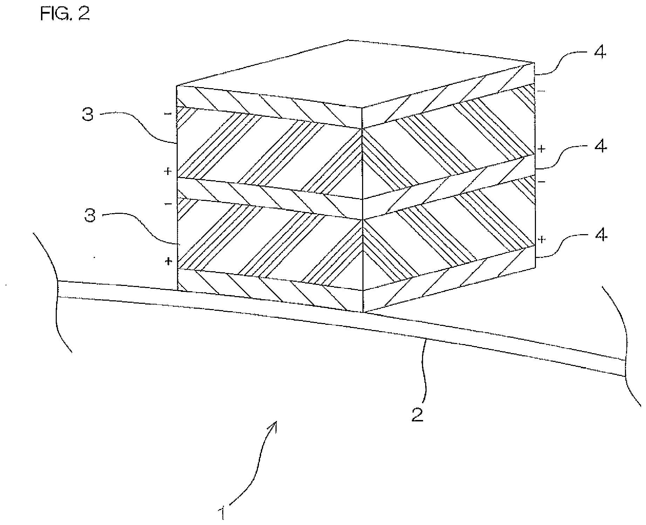

FIG. 2 is a schematic diagram illustrating the configuration of an embodiment (First Embodiment) of the first device shown in FIG. 1.

The above-described first device 3 can also be used, as shown in FIG. 2, for example, in a stack.

In this case, the second devices 4 (e.g., electrode, lead wire, etc.) to be described later are interposed between the plurality of first devices 3 (preferably, pyroelectric element), thus connecting the first devices 3 electrically in series at the time of polarization.

Then, the thus obtained stack of the first devices 3 is disposed, as shown in FIG. 1, so as to be in contact with or in the proximity of the heat source 2, and the stacked first devices 3 are simultaneously heated or cooled.

Polarization is caused simultaneously in the plurality of first devices 3 and electrical connection in series is allowed in this manner, and as a result, compared with the case where the first device 3 is used singly (as a single layer), a high net generating power can be taken out.

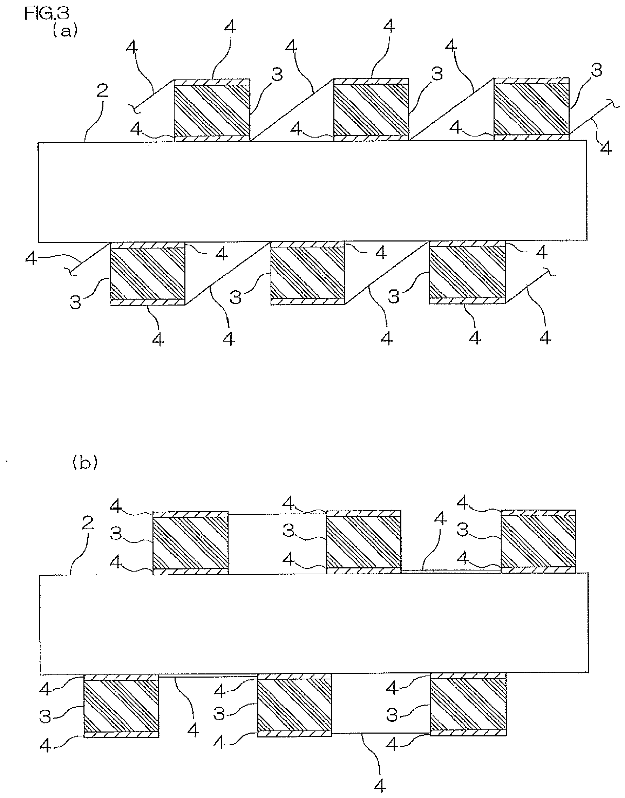

FIG. 3 is a schematic diagram illustrating the configuration of another embodiment of the first device shown in FIG. 1.

The above-described first device 3 can also be used, as shown in FIG. 3, for example, by arranging the first devices 3 in line on the same plane.

In this case, the second devices 4 (e.g., electrode, lead wire, etc.) to be described later are provided between the plurality of first devices 3, thus connecting the first devices 3 electrically in series at the time of polarization.

Then, the plurality of first devices 3 thus arranged in line are disposed, as shown in FIG. 1, so as to be in contact with or in the proximity of the heat source 2, and all of the first devices 3 arranged in line are heated or cooled simultaneously.

Polarization is caused simultaneously in the plurality of first devices 3 and electrical connection in series is allowed in this manner, and as a result, compared with the case where the first device 3 is used singly, a high net generating power can be taken out.

At that time, for example, when the first device 3 is a pyroelectric element, or when only a thermoelectric element composed of p-type semiconductor or a thermoelectric element composed of n-type semiconductor is used, in the first devices 3, polarization occurs so that one side that is in contact with or in the proximity of the heat source 2 is all positive electrodes or negative electrodes, and the other side that is distant from the heat source 2 is all negative electrodes or positive electrodes (ref: FIG. 3 (a)).

Therefore, in such a case, the side making contact with or in the proximity of the heat source 2 in one first device 3 is electrically connected with the side distant from the heat source 2 in another first device 3.

On the other hand, when a thermoelectric element composed of p-type semiconductor, and a thermoelectric element composed of n-type semiconductor are used as the first device 3, and these are disposed alternately, polarization occurs oppositely in the thermoelectric element composed of p-type semiconductor and the thermoelectric element composed of n-type semiconductor, and therefore at one side of the first devices 3 that is brought into contact with or in the proximity of the heat source 2, a positive electrode and a negative electrode are alternately arranged in line.

Thus, in such a case, the side making contact with or in the proximity of the heat source 2 in one first device 3 is electrically connected with the side making contact with or in the proximity of the heat source 2 in another first device 3, and the side distant from the heat source 2 in one first device 3 is electrically connected with the side distant from the heat source 2 of another first device 3 (ref: FIG. 3 (b)).

In FIG. 1, the second device 4 is provided so as to take out a net generating power from the first device 3.

Such a second device 4 is not particularly limited, and includes, for example, two electrodes (e.g., copper electrode, silver electrode, etc.) that are disposed to face each other with the above-described first device 3 sandwiched therebetween, and lead wires to be connected to these electrodes; and is electrically connected to the first device 3.

In a power-generating system 1 shown in FIG. 1, the second device 4 is electrically connected to, in sequence, a booster 5, an alternating current/direct current converter (AC-DC converter) 6, and a battery 7.

To generate electricity by such a power-generating system 1, for example, first, the temperature of the heat source 2 is increased or decreased over time; preferably, the temperature is changed periodically to cause temperature change over time, preferably periodically in the above-described first device 3 in accordance with the temperature change to cause polarization.

Thereafter, through the second device 4, a net generating power is taken out as a periodically changing waveform (e.g., alternating current, pulsating current, etc.) in accordance with the periodical polarization of the first device 3.

To be more specific, in the power-generating system 1, the heat source 2 causes the temperature of the first device 3 to change over time so as to include at least partially a temperature range of -20°C relative to the Curie temperature to +10°C relative to the Curie temperature.

That is, in the power-generating system 1, the first device 3 undergoes temperature change so that its temperature at high-temperature state is higher than the low-temperature state temperature and is -20°C or higher relative to the Curie temperature, and so that its low-temperature state temperature is below the above-described high-temperature state temperature and is +10°C or lower relative to the Curie temperature.

Furthermore, preferably, the temperature change is caused over time so that the first device 3 include at least partially a temperature range of -18°C relative to the Curie temperature to +8°C relative to the Curie temperature, and more preferably, to include at least partially a temperature range of -15°C relative to the Curie temperature to +5°C relative to the Curie temperature.

The temperature of the first device 3 can be changed so as not to include its Curie temperature.

To be specific, the temperature of the first device 3 can be changed, for example, so that both of the high-temperature state temperature and the low-temperature state temperature are higher than the Curie temperature, and so that the low-temperature state temperature is +10°C or lower relative to the Curie temperature. The temperature of the first device 3 can also be changed, for example, so that both of the high-temperature state temperature and the low-temperature state temperature are below the Curie temperature, and so that the high-temperature state temperature is -20°C or higher relative to the Curie temperature.

Furthermore, the temperature of the first device 3 can be changed so as to include its Curie temperature. That is, the temperature of the first device 3 can be changed so that the high-temperature state temperature is higher than the Curie temperature, and that the low-temperature state temperature is below the Curie temperature.

The temperature of the first device 3 preferably changes so as to include its Curie temperature.

In such a power-generating system 1, generally, the greater the change in the temperature of the first device 3, the higher the voltage can be taken out. However, when the temperature of the first device 3 changes over time so as to include at least partially a temperature range of -20°C relative to the Curie temperature to +10°C relative to the Curie temperature, even with a small amount of change in the temperature, a high voltage can be taken out, and electricity generation with excellent efficiency is possible.

The temperature of the first device 3 is, to be specific, as follows: Its low-temperature state temperature is, for example, -40°C or higher relative to the Curie temperature, preferably -30°C or higher relative to the Curie temperature, more preferably -20°C or higher relative to the Curie temperature, and its high-temperature state temperature is, +30°C or lower relative to the Curie temperature, preferably +20°C or lower relative to the Curie temperature, more preferably +10°C or lower relative to the Curie temperature.

That is, the temperature of the first device 3 changes more preferably in the range of -20°C relative to the Curie temperature to +10°C relative to the Curie temperature.

In such a case, the temperature of the first device 3 is as follows. Its high-temperature state temperature is, for example, 30 to 1200°C, preferably 100 to 800°C, more preferably 300 to 350°C, even more preferably 310 to 325°C; its low-temperature state temperature is below the above-described high-temperature state temperature; and the temperature difference between the high-temperature state temperature and the low-temperature state temperature is, for example, 10 to 100°C, preferably 20 to 50°C.

The repetition cycle of the high-temperature state and low-temperature state is, for example, 10 to 400 cycles/sec, preferably 30 to 100 cycles/sec.

The temperature of the first device 3 can be measured, for example, by an infrared thermometer.

The temperature of the heat source 2 is set in a range that allows the first device 3 to change its temperature in the above-described range.

To be more specific, the temperature of the heat source 2 is as follows. Its high-temperature state temperature is, for example, 500 to 1200°C, preferably 700 to 900°C; its low-temperature state temperature is below the above-described high-temperature state temperature, to be more specific, for example, 200 to 800°C, preferably 200 to 500°C; and the temperature difference between the high-temperature state temperature and the low-temperature state temperature is, for example, 10 to 600°C, preferably 20 to 500°C.

The repetition cycle of the high-temperature state and low-temperature state is, for example, 10 to 400 cycles/sec, preferably 30 to 100 cycles/sec.

The net generating power thus taken out from the power-generating system 1 is boosted in the booster 5 connected to the second device 4, as in a state of a periodically changing waveform (e.g., alternating current, pulsating current, etc.). For the booster 5, a booster that is capable of boosting the alternating current voltage with excellent efficiency with a simple structure using, for example, a coil, condenser, etc is used.

Then, the net generating power with its voltage boosted by the booster 5 is converted to a direct current voltage in the alternating current/direct current converter 6, and thereafter, stored in the battery 7.

In such a power-generating system 1, the heat source 2 having a temporal temperature variation is used, and therefore a changing voltage (e.g., alternating current voltage) can be taken out, and as a result, compared with the case where a constant voltage (direct current voltage) is taken out and converted with a DC-DC converter, excellently efficient boosting of voltage and storage of electricity can be achieved.

Furthermore, when the heat source 2 is a heat source that periodically undergoes temperature change, the net generating power can be taken out as a periodically changing waveform, and as a result, more excellently efficient boosting of voltage and storage of electricity can be achieved.

Particularly, with such a power-generating system 1, improvement in power generation efficiency can be achieved.

That is, in such a power-generating system 1, generally, the more the amount of change in the temperature of the first device 3, the higher the voltage can be taken out, but in this power-generating system 1, the first device 3 undergoes temperature changes over time so as to include at least partially a temperature range of -20°C relative to the Curie temperature to +10°C relative to the Curie temperature, and therefore even with a small amount of temperature change, electricity can be generated with excellent efficiency.

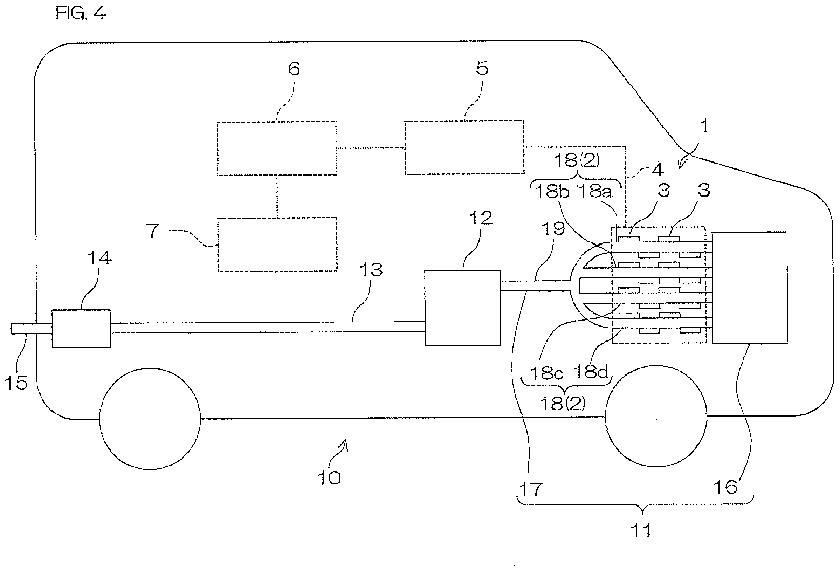

FIG. 4 is a schematic diagram illustrating the configuration of an embodiment (First Embodiment) of a power-generating system of the present invention on board.

In FIG. 4, an automobile 10 includes an internal combustion engine 11, a catalyst mount portion 12, an exhaust pipe 13, a muffler 14, and an outlet pipe 15.

The internal combustion engine 11 includes an engine 16, and an exhaust manifold 17.

The engine 16 is a four cylinder, four-stroke cycle engine, and upstream end portions of branch pipes 18 (described later) of the exhaust manifold 17 are connected to the cylinders.

The exhaust manifold 17 is provided for collecting the exhaust gas discharged from the cylinders of the engine 16; and includes a plurality of (four) branch pipes 18 (when these have to be distinguished, these are referred to as, from the top in FIG. 4, a branch pipe 18a, a branch pipe 18b, a branch pipe 18c, and a branch pipe 18d.) connected to the cylinders of the engine 16, and a collection pipe 19 that integrates the branch pipes 18 at a downstream side of the branch pipes 18.

In such an exhaust manifold 17, the upstream end portions of the branch pipes 18 are connected to the cylinders of the engine 16, and the downstream end portions of the branch pipes 18 are connected to the upstream end portion of the collection pipe 19. The downstream end portion of the collection pipe 19 is connected to the upstream end portion of the catalyst mount portion 12.

The catalyst mount portion 12 includes, for example, a catalyst carrier and a catalyst coated thereon, and is connected to the downstream end portion of the internal combustion engine 11 (exhaust manifold 17) to purify toxic components such as hydrocarbon (HC), nitrogen oxide (NOx), and carbon monoxide (CO) contained in the exhaust gas discharged from the internal combustion engine 11.

The exhaust pipe 13 is provided for guiding the exhaust gas purified at the catalyst mount portion 12 to the muffler 14, and the upstream end portion thereof is connected to the catalyst mount portion 12, and the downstream end portion thereof is connected to the muffler 14.

The muffler 14 is provided to reduce the noise generated in the engine 16 (in particular, power stroke), and the upstream end portion thereof is connected to the downstream end portion of the exhaust pipe 13. The downstream end portion of the muffler 14 is connected to the upstream end portion of the outlet pipe 15.

The outlet pipe 15 is provided for releasing, into the air, the exhaust gas that was discharged from the engine 16, and was purified, with its noise reduced passing through the exhaust manifold 17, the catalyst mount portion 12, the exhaust pipe 13, and the muffler 14 sequentially. The upstream end portion of the outlet pipe 15 is connected to the downstream end portion of the muffler 14, and the downstream end portion of the outlet pipe 15 is open into the air.

The automobile 10 is equipped with, as shown by the dotted line in FIG. 4, the power-generating system 1.

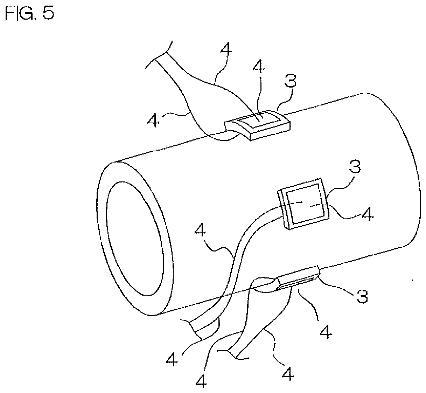

FIG. 5 is an enlarged view of a relevant part of the power-generating system shown in FIG. 4.

In FIG. 5, the power-generating system 1 includes, as described above, the heat source 2, the first device 3, and the second device 4.

In the power-generating system 1, the branch pipe 18 of the exhaust manifold 17 in the internal combustion engine 11 is used as the heat source 2, and the first device 3 is disposed around the branch pipe 18.

Examples of the first device 3 that may be used are, as described above, a known pyroelectric element (e.g., $BaTiO_3$, $CaTiO_3$, $(CaBi)TiO_3$, $BaNd_2Ti_5O_{14}$, $BaSm_2Ti_4O_{12}$, lead zirconate titanate (PZT: $Pb(Zr,Ti)O_3$), etc.), a known thermoelectric element (e.g., Bi-Te thermoelectric element (e.g., $Bi_2Te_3$, $Bi_2Te_3/Sb_2Te_3$, etc.)), PbTe, $AgSbTe_2/GeTe$, $NaCo_2O_4$, $CaCoO_3$, $SrTiO_3/SrTiO_3$: Nb, SiGe, $\beta$-$FeSi_2$, $Ba_8Si_{46}$, $Mg_2Si$, $MnSi_{1.73}$, ZnSb, $Zn_4Sb_3$, $CeFe_3CoSb_{12}$, $LaFe_3CoSb_{12}$, $SrTiO_3/SrTiO_3$: $Nb/SrTiO_3$, Si nanowire array, $NaCo_2O_4$, $(Ce_{1-x}La_x)Ni_2$, $(Ce_{1-x}La_x)In_3$, $CeInCu_2$, $NaV_2O_5$, $V_2O_5$, etc.), and a known piezoelectric element (e.g., crystal ($SiO_2$), zinc oxide (ZnO), Rochelle salt (potassium sodium tartrate)($KNaC_4H_4O_6$), lead zirconate titanate (PZT: $Pb(Zr,Ti)O_3$), lithium niobate ($LiNbO_3$), lithium tantalate ($LiTaO_3$), lithium tetraborate ($Li_2B_4O_7$), langasite ($La_3Ga_5SiO_{14}$), aluminum nitride (AlN), tourmaline, polyvinylidene fluoride (PVDF), etc.).

The Curie temperature of such a first device 3 is, for example, -30 to 1500°C, preferably -10 to 1200°C, more preferably 10 to 1000°C.

Furthermore, when the first device 3 is a pyroelectric element and/or piezoelectric element (insulator (dielectric)), the relative dielectric constant is, for example, 1 or higher, preferably 100 or higher, more preferably 2000 or higher.

In such a power-generating system 1, higher the relative dielectric constant of the first device 3 (insulator (dielectric)) is, the higher the energy conversion efficiency is, which allows for obtainment of a net generating power at high voltage. However, when the relative dielectric constant of the first device 3 is below the above-described lower limit, the energy conversion efficiency is low, and the voltage of the obtained net generating power may be low.

In the first device 3 (insulator (dielectric)), polarization occurs by the temperature change of the heat source 2, and the polarization may be any of electronic polarization, ionic polarization, and orientation polarization.

For example, it has been expected that with those materials in which polarization occurs by orientation polarization (e.g., liquid crystal material, etc.), improvement in power generation efficiency can be achieved by changing its molecule structure.

When the first device 3 is a thermoelectric element, its performance is represented, for example, by the following formula (1).

$$ZT = S^2\sigma T/\kappa \; (1)$$

(where Z represents figure of merit, T represents the absolute temperature, S represents the Seebeck coefficient, $\sigma$ represents electric conductivity, and $\kappa$ represents thermal conductivity.)

In the first device 3 (thermoelectric element), the ZT value (dimensionless figure of merit) is, for example, 0.3 or higher.

When the ZT value (dimensionless figure of merit) is below the above-described lower limit, the energy conversion efficiency is low, and the voltage of the obtained net generating power may be low.

Furthermore, because the thermoelectric element usually generates electricity based on the temperature difference inside the material, the lower the thermal conductivity of the thermoelectric element is, the higher the energy conversion efficiency is. However, in this power-generating system 1, the temperature difference at the both ends of the first device 3 (thermoelectric element) is not necessary, and therefore the thermal conductivity of the first device 3 (thermoelectric element) is not particularly limited.

The second device 4 includes two electrodes that are disposed to face each other with the first device 3 sandwiched therebetween, and lead wires connected to these electrodes. The electrode and the lead wire that are disposed at one side surface of the first device 3 are disposed so as to be interposed between the first device 3 and the branch pipe 18 (heat source 2), and the electrode and the lead wire that are disposed at the other side surface of the first device 3 are exposed without making contact with the branch pipe 18 (heat source 2).

As shown in FIG. 4, the power-generating system 1 is electrically connected, in sequence, to the booster 5, the alternating current/direct current converter 6, and the battery 7.

In such an automobile 10, the engine 16 is driven by repetitive up-down motion of pistons in cylinders, performing the intake stroke, the compression stroke, the power stroke, and the exhaust stroke in sequence.

To be more specific, for example, in the two cylinders of the cylinder connected to the branch pipe 18a and the cylinder connected to the branch pipe 18c, the pistons work together to conduct the intake stroke, the compression stroke, the power stroke, and the exhaust stroke synchronously. This allows fuel combustion and output of motive power, allowing a high temperature exhaust gas to pass through inside of the branch pipe 18a and the branch pipe 18c in the exhaust stroke.

At this time, the temperature of the branch pipe 18a and the branch pipe 18c increases in the exhaust stroke, and decreases in other strokes (intake stroke, compression stroke, and power stroke), and therefore increases and decreases over time in accordance with the piston cycle, thus repeating a high-temperature state and a low-temperature state periodically.

On the other hand, at different timing from these two cylinders, in the two cylinders of the cylinder connected to the branch pipe 18b and the cylinder connected to the branch pipe 18d, pistons work together to conduct the intake stroke, the compression stroke, the power stroke, and the exhaust stroke synchronously. This allows fuel combustion and output of motive power at different timing from the branch pipe 18a and the branch pipe 18c, allowing a high temperature exhaust gas to pass through inside of the branch pipe 18b and the branch pipe 18d in the exhaust stroke.

At this time, the temperature of the branch pipe 18b and the branch pipe 18d increases in the exhaust stroke, and decreases in other strokes (intake stroke, compression stroke, and power stroke), and therefore increases and decreases over time in accordance with the piston cycle, thus repeating a high-temperature state and a low-temperature state periodically.

The periodic temperature change occurs at the same period, but at a different phase from the periodic temperature change of the branch pipe 18a and the branch pipe 18c.

In the power-generating system 1, the first device 3 is disposed at every branch pipe 18 (heat source 2).

Thus, a periodic high-temperature state or low-temperature state can be caused in the first device 3 based on the temperature change over time of the branch pipe 18 (heat source 2), and polarization can be caused in the first device 3 in accordance with the effects (e.g., piezoelectric effect, pyroelectric effect, Seebeck effect, etc.) of the element (e.g., piezoelectric element, pyroelectric element, thermoelectric element, etc.).

Thus, in the power-generating system 1, a net generating power can be taken out from the first devices 3 via the second devices 4 as a periodically changing waveform (e.g., alternating current, pulsating current, etc.).

Furthermore, in the power-generating system 1, the temperature of the branch pipe 18a and the branch pipe 18c, and the temperature of the branch pipe 18b and the branch pipe 18d change at the same period, but at a different phase periodically, and therefore a net generating power can be taken out continuously as a periodically changing waveform (e.g., alternating current, pulsating current, etc.).

Then, the exhaust gas passes through the branch pipes 18, and then is supplied to the collection pipe 19. After the collection, the exhaust gas is supplied to the catalyst mount portion 12, and is purified by the catalyst provided in the catalyst mount portion 12. Thereafter, the exhaust gas is supplied to the exhaust pipe 13, and after the noise is reduced in the muffler 14, the exhaust gas is discharged outside through the outlet pipe 15.

At this time, the exhaust gas that passes through the branch pipes 18 is collected in the collection pipe 19, and therefore the temperature of the exhaust gas that passes through the collection pipe 19, the catalyst mount portion 12, the exhaust pipe 13, the muffler 14, and the outlet pipe 15 in sequence is smoothed.

Thus, the temperature of the collection pipe 19, the catalyst mount portion 12, the exhaust pipe 13, the muffler 14, and the outlet pipe 15, which allow the exhaust gas with its temperature smoothed to pass through, usually does not change over time, keeping a substantially constant temperature.

Therefore, when the collection pipe 19, the catalyst mount portion 12, the exhaust pipe 13, the muffler 14, or the outlet pipe 15 is used as the heat source 2, and the above-described first devices 3 are disposed at the surrounding thereof with the second device 4 interposed therebetween, the voltage of the net generating power taken out from the first device 3 is small, and also is constant (direct current voltage).

Thus, in such a method, the voltage of the obtained net generating power cannot be increased efficiently with a simple structure, which is disadvantageous in that storage of electricity is inefficient.

On the other hand, as described above, in the power-generating system 1 in which the internal combustion engine 11 (branch pipe 18) is used as the heat source 2, a periodic high-temperature state or low-temperature state is allowed in the first device 3 based on the temperature change over time of the heat source 2, and periodic polarization can be caused in the first device 3 in accordance with the effects (e.g., piezoelectric effect, pyroelectric effect, Seebeck effect, etc.) of the device (e.g., piezoelectric element, pyroelectric element, thermoelectric element, etc.).

Thus, in the power-generating system 1, a net generating power can be taken out from the first devices 3 via the second devices 4 as a periodically changing waveform (e.g., alternating current, pulsating current, etc.).

Thereafter, in this method, for example, as shown by the dotted line in FIG. 4, the voltage of the net generating power obtained as described above is increased in the booster 5 connected to the second device 4 under the state of a periodically changing waveform (e.g., alternating current, pulsating current, etc.), and then after the net generating power with its voltage boosted is converted to a direct current voltage in an alternating current/direct current converter 6, the net generating power is stored in the battery 7. The net generating power stored in the battery 7 is used suitably as a motive power for the automobile 10, or for various electrical accessories mounted in the automobile 10.

In particular, with such a power-generating system 1, power generation efficiency can be improved.

Thus, in such a power-generating system 1, the heat source 2 having a temporal temperature variation is used, and therefore a changing voltage (e.g., alternating current voltage) can be taken out, and as a result, compared with the case where a constant voltage (direct current voltage) is taken out and converted with a DC-DC converter, excellently efficient boosting of voltage and storage of electricity can be achieved.

Particularly, with such a power-generating system 1, the first device 3 undergoes temperature change over time so as to include at least partially a temperature range of -20°C relative to the Curie temperature to +10°C relative to the Curie temperature, and therefore electricity can be generated with excellent efficiency.

Although not shown in detail, in application, the first device 3 can be stacked, as shown in FIG. 2, and furthermore, as shown in FIG. 3, the first device 3 can also be arranged in line on the same plane depending on the types, necessity, and application.

When the first device 3 is stacked and/or arranged in line on the same plane in its application, polarization can be caused in a plurality of first devices 3 simultaneously, and the first devices 3 can be electrically connected in series, and as a result, a high net generating power can be taken out compared with the case where the first device 3 is used singly.

In the description above, the first device 3 is disposed around (outer wall) the branch pipe 18, but the first device 3 is preferably disposed inside (e.g., inner wall) the branch pipe 18 so as to conduct the temperature change to the first device 3 without averaging the temperature.

<Second Embodiment)

In the following, a second embodiment of the present invention is described.

Figures describing the first embodiment above are also the same in the second embodiment.

Detailed description for the same member and principle as in the first embodiment above is omitted.

In the second embodiment, a composite element (described later) is used as the above-described first device 3.

To be specific, in the second embodiment, instead of the piezoelectric element, a composite element (hereinafter piezo-based composite element) obtained by using a known piezoelectric element material as the matrix material, which is to be described in detail later, may be used. Furthermore, instead of the pyroelectric element, a composite element (hereinafter pyroelectric-based composite element) obtained by using a known pyroelectric element material as the matrix material, which is to be described later, may be used. Furthermore, instead of the thermoelectric element, a composite element (hereinafter thermoelectric-based composite element) obtained by using a known thermoelectric element material as the matrix material, which is to be described later, may be used.

When a piezo-based composite element (described later) is used as the first device 3, the piezo-based composite element (described later) is disposed, for example, so that the piezo-based composite element is brought in the proximity of the heat source 2, or into contact with the heat source 2 with the electrode to be described later interposed therebetween while the surrounding thereof is fixed by a fixing member to suppress the volume expansion thereof. The fixing member is not particularly limited, and for example, the second device 4 (e.g., electrode, etc.) to be described later may also be used.

In this case, the piezo-based composite element (described later) is heated or cooled by the temperature change over time of the heat source 2, which allows expansion or shrinkage thereof.

In such a case, the volume expansion of the piezo-based composite element (described later) is suppressed by the fixing member, and therefore the piezo-based composite element (described later) is pressed by the fixing member, which allows polarization to occur by the piezoelectric effect or phase transformation near the Curie temperature. In this manner, although to be described later, a net generating power is taken out from the piezo-based composite element (described later) via the second device 4.

In such a piezo-based composite element (described later), usually, a heated state or a cooled state is kept, and when its temperature becomes constant (that is, the volume is constant), the polarization is neutralized, and by cooling or heating thereafter, the piezoelectric element undergoes polarization again.

Thus, as described above, when the temperature of the heat source 2 changes periodically, and a high-temperature state and a low-temperature state are periodically repeated, the piezo-based composite element (described later) is heated and cooled repeatedly and periodically, and therefore polarization and neutralization of the piezo-based composite element (described later) are periodically repeated.

As a result, a net generating power can be taken out as a periodically changing waveform (e.g., alternating current, pulsating current, etc.) by the second device 4 to be described later.

When a pyroelectric-based composite element (described later) is used as the first device 3, the pyroelectric-based composite element (described later) is disposed, for example, in the proximity of the heat source 2, or so as to be in contact with the heat source 2 with an electrode to be described later interposed therebetween.

In such a case, the pyroelectric-based composite element (described later) is heated or cooled by temperature changes over time of the heat source 2, and undergoes polarization by its pyroelectric effect (including the first effect and second effect). In this manner, although to be described later, a net generating power is taken out from the pyroelectric-based composite element (described later) via the second device 4.

In such a pyroelectric-based composite element (described later), usually, a heated state or a cooled state is kept, and when its temperature becomes constant, the polarization is neutralized, and by cooling or heating thereafter, the pyroelectric-based composite element (described later) undergoes polarization again.

Thus, as described above, when the temperature of the heat source 2 changes periodically, and a high-temperature state and a low-temperature state are periodically repeated, the pyroelectric-based composite element (described later) is heated and cooled periodically and repeatedly, and therefore the polarization and neutralization of the pyroelectric-based composite element (described later) are periodically repeated.

As a result, a net generating power can be taken out as a periodically changing waveform (e.g., alternating current, pulsating current, etc.) by the second device 4 to be described later.

When a thermoelectric-based composite element (described later) is used as the first device 3, the thermoelectric-based composite element (described later) is disposed, for example, so that one end portion thereof is brought in the proximity of the heat source 2, or into contact with the heat source 2 with the electrode to be described later interposed therebetween, and the other end portion thereof is distant from the heat source 2.

In this case, only one end portion of the thermoelectric-based composite element (described later) is heated or cooled by the temperature change over time of the heat source 2, and a temperature difference is caused between the both ends (between one end portion and the other end portion thereof) of the thermoelectric-based composite element (described later). At this time, an electromotive force is generated in the thermoelectric-based composite element (described later) by the Seebeck effect. In this manner, although to be described later, a net generating power is taken out from the thermoelectric-based composite element (described later) via the second device 4.

In such a thermoelectric-based composite element (described later), when the temperature difference between the both ends is large, the electromotive force is high, which allows for obtainment of a high net generating power. On the other hand, when the temperature difference is small, the electromotive force is small, which decreases the net generating power to be taken out.

Thus, as described above, when the temperature of the heat source 2 changes periodically, and a high-temperature state and a low-temperature state are periodically repeated, the temperature of the one end portion of the thermoelectric-based composite element (described later) increases or decreases repeatedly and periodically, and therefore the degree of the electromotive force increases or decreases periodically in accordance with the temperature change.

As a result, a net generating power can be taken out as a periodically changing waveform (e.g., alternating current, pulsating current, etc.) by the second device 4 to be described later.

In such a power-generating system 1, the heat source 2 causes the first device 3 to undergo temperature change over time, but unlike the first embodiment above, its temperature does not depend on the Curie temperature of the first device 3.

To be specific, in such a power-generating system 1, the temperature of the heat source 2 during the high-temperature state is, for example, 500 to 1200°C, preferably 700 to 900°C; temperature of the heat source 2 during the low-temperature state is below the above-described high-temperature state temperature, to be more specific, for example, 200 to 800°C, preferably 200 to 500°C; and the temperature difference between the high-temperature state and the low-temperature state is, for example, 10 to 600°C, preferably 20 to 500°C.

The repetition cycle of the high-temperature state and low-temperature state is, for example, 10 to 400 cycles/sec, preferably 30 to 100 cycles/sec.

The net generating power thus taken out from the power-generating system 1 is boosted in the booster 5 connected to the second device 4, as in a state of a periodically changing waveform (e.g., alternating current, pulsating current, etc.). For the booster 5, a booster that is capable of boosting the alternating current voltage with excellent efficiency with a simple structure using, for example, a coil, condenser, etc is used.

Then, the net generating power with its voltage boosted by the booster 5 is converted to a direct current voltage in the alternating current/direct current converter 6, and thereafter, stored in the battery 7.

In such a power-generating system 1, the heat source 2 having a temporal temperature variation is used, and therefore a changing voltage (e.g., alternating current voltage) can be taken out, and as a result, compared with the case where a constant voltage (direct current voltage) is taken out and converted with a DC-DC converter, excellently efficient boosting of voltage and storage of electricity can be achieved.

Furthermore, the above-described first device 3 is a composite element composed of a matrix that is capable of polarization, and a dispersion material having a specific heat capacity that is lower than the specific heat capacity of the matrix; and is formed by dispersing the dispersion material in the matrix.

Such a composite element can be obtained, for example, by mixing a matrix material powder for forming the matrix and a dispersion material powder and dispersing the dispersion material in the matrix material, thereby producing their mixture.

Examples of the matrix material include known pyroelectric element materials (e.g., $BaTiO_3$, $CaTiO_3$,

$(CaBi)TiO_3$, $BaNd_2Ti_5O_{14}$, $BaSm_2Ti_4O_{12}$, lead zirconate titanate (PZT: $Pb (Zr,Ti) O_3$), etc.), known thermoelectric element materials (e.g., Bi-Te-based thermoelectric element (e.g., $Bi_2Te_3$, $Bi_2Te_3/Sb_2Te_3$, etc.)), PbTe, $AgSbTe_2/GeTe$, $NaCo_2O_4$, $CaCoO_3$, $SrTiO_3/SrTiO_3$: Nb, SiGe, $\beta$-$FeSi_2$, $Ba_8Si_{46}$, $Mg_2Si$, $MnSi_{1.73}$, ZnSb, $Zn_4Sb_3$, $CeFe_3CoSb_{12}$, $LaFe_3CoSb_{12}$, $SrTiO_3/SrTiO_3$: Nb/$SrTiO_3$, Si nanowire array, $NaCo_2O_4$, $(Ce_{1-x}La_x)Ni_2$, $(Ce_{1-x}La_x)In_3$, $CeInCu_2$, $NaV_2O_5$, $V_2O_5$, etc.), known piezoelectric element materials (e.g., crystal ($SiO_2$), aluminum oxide ($Al_2O_3$), zinc oxide (ZnO), Rochelle salt (potassium sodium tartrate)($KNaC_4H_4O_6$), lead zirconate titanate (PZT: $Pb (Zr,Ti)O_3$), lithium niobate ($LiNbO_3$), lithium tantalate ($LiTaO_3$), lithium tetraborate ($Li_2B_4O_7$), langasite ($La_3Ga_5SiO_{14}$), aluminum nitride (AlN), tourmaline, and polyvinylidene fluoride (PVDF), etc.).

These matrix materials may be used singly or in combination of two or more.

When the pyroelectric element material is used as the matrix material, a composite element (pyroelectric-based composite element) that undergoes polarization by pyroelectric effect can be obtained; when the thermoelectric element material is used, a composite element (thermoelectric-based composite element) that undergoes polarization by Seebeck effect can be obtained; and furthermore, when the piezoelectric element material is used, a composite element (piezo-based composite element) that undergoes polarization by piezoelectric effect can be obtained.

The matrix material has an average particle size (measurement method: scanning electron microscope) of, for example, 0.1 to 100 $\mu m$, preferably 0.5 to 10 $\mu m$.

This is because when the matrix material has a particle size of below the above-described range, the fraction of the grain boundary increases and the dielectric constant becomes largely dependent on the temperature, the temperature range that can be used becomes narrow, and on the other hand, when the matrix material has a particle size of more than the above-described range, the fracture origin size of the matrix material becomes large and causes the strength of the material to decrease.

The matrix material, and also the matrix formed from the matrix material has a specific heat capacity of, for example, 0.01 to 10J/g·K, preferably 0.1 to 5J/g·K.

This is because when the matrix material, and also the matrix made from the matrix material has a specific heat capacity that is too low, heat from the heat source immediately raise the temperature of the entire material, the thermal stress becomes significantly high at the interface of, for example, the material and the electrode, which may cause the electrode to detach, on the other hand, when the specific heat capacity is too high, the temperature change inside the material becomes less responsive to the heat change from outside, and therefore the power generation using temperature change, i.e., a purpose in the present invention, becomes difficult.

The dispersion material is not particularly limited, as long as the dispersion material has a specific heat capacity that is lower than the specific heat capacity of the matrix material and of the matrix formed from the matrix material, and for example, elements of noble metals such as Ru (ruthenium), Rh (rhodium), Pd (palladium), Ag (silver), Os (osmium), Ir (iridium), and Pt (platinum); elements of transition metals such as Cr (chromium), Mn (manganese), Fe (iron), Co (cobalt), Ni (nickel), Cu (copper), and Zn (zinc); and oxide, carbonate, nitrate, sulfate, diketone metal complex, and hydride complex of these may be used.

These dispersion materials may be used singly or in combination of two or more.

The dispersion material is preferably a dispersion material that is in the state of reduced state at 200 to 1000°C, more preferably at 200 to 500°C. Examples of such dispersion materials include, to be specific, oxides, carbonates, nitrates, sulfates, diketone metal complexes, hydride complexes of, for example, Rh (rhodium), Pd (palladium), Ag (silver), Pt (platinum), Cr (chromium), Ni (nickel), and Cu (copper).

Use of such a dispersion material allows for decomposition of the dispersion material by reduction at the time of sintering (described later) of the matrix, and therefore a fine dispersed phase can be formed.

The dispersion material has an average particle size (measurement method: scanning electron microscope) of, for example, 0.002 to 10 nm, preferably 0.01 to 3 nm.

This is because when the dispersed phase becomes too small, the sintering (described later) of the matrix may be hindered, and when the dispersed phase becomes too large, separation from the matrix easily occur, decreasing the effects of electric conduction, thermal conduction, and mechanical characteristics by forming composites.

The dispersion material has a specific heat capacity of, in view of changing the temperature inside the composite element in accordance with the heat source given from outside, lower than the specific heat capacity of the above-described matrix material, and the matrix formed from the matrix material, to be specific, for example, 0.01 to 10J/g·K, preferably 0.1 to 5J/g·K.

The mixing ratio of the dispersion material to the matrix material is, for example, 0.01 to 50 parts by mass, preferably 0.1 to 40 parts by mass of the dispersion material relative to 100 parts by mass of the matrix material.

In this method, the matrix material and the dispersion material are mixed by, for example, a known mixing method such as dry mixing, and wet blending, and as necessary, molded by using a mold (e.g., press molding), thereby producing a composite element in which the dispersion material is dispersed in the matrix.

Furthermore, in this method, as necessary, the composite element can be sintered.

The sintering conditions are, for example, as follows: under an inert gas atmosphere, the heating temperature is, for example, 500 to 1800°C, preferably 800 to 1500°C, and the heating time of, for example, 0.1 to 24 hours, preferably 0.5 to 4 hours. These conditions are suitably optimized so as to improve most the density of the composite element depending the volume and shape of the sample.

When such a first device 3 is used, to be specific, a first device 3 composed of a matrix that is capable of polarization, and a dispersion material having a specific heat capacity that is lower than the specific heat capacity of the matrix, compared with the case where a device that is capable of polarization is simply used as the first device 3, electricity can be generated with excellent efficiency.

Furthermore, when the first device 3 is a pyroelectric-based composite element and/or a piezo-based composite element (insulator (dielectric)), the relative dielectric constant is, for example, 1 or higher, preferably 100 or higher, more preferably 2000 or higher.

In such a power-generating system 1, higher the relative dielectric constant of the first device 3 (insulator (dielectric)) is, the higher the energy conversion efficiency is, which allows for obtainment of a net generating power at high voltage. However, when the relative dielectric constant of the first device 3 is below the above-described lower limit, the energy conversion efficiency is low, and the voltage of the obtained net generating power may be low.

In the first device 3 (insulator (dielectric)), polarization occurs by the temperature change of the heat source 2, and the polarization may be any of electronic polarization, ionic polarization, and orientation polarization.

For example, it has been expected that with those materials in which polarization occurs by orientation polarization (e.g., liquid crystal material, etc.), improvement in power generation efficiency can be achieved by changing its molecule structure.

When the first device 3 is a thermoelectric-based composite element, its performance is represented, for example, by the following formula (1).

$$ZT = S^2 \sigma T / \kappa \ (1)$$

(where Z represents figure of merit, T represents the absolute temperature, S represents the Seebeck coefficient, $\sigma$ represents electric conductivity, and $\kappa$ represents thermal conductivity.) In the first device 3 (thermoelectric-based composite element), the ZT value (dimensionless figure of merit) is, for example, 0.3 or higher.

When the ZT value (dimensionless figure of merit) is below the above-described lower limit, the energy conversion efficiency is low, and the voltage of the obtained net generating power may be low.

Furthermore, because the thermoelectric-based composite element usually generates electricity based on the temperature difference inside the material, the lower the thermal conductivity of the thermoelectric element is, the higher the energy conversion efficiency is. However, in this power-generating system 1, the temperature difference at the both ends of the first device 3 (thermoelectric-based composite element) is not necessary, and therefore the thermal conductivity of the first device 3 (thermoelectric-based composite element) is not particularly limited.

In such a power-generating system 1, the heat source 2 having a temporal temperature variation is used, and therefore a changing voltage (e.g., alternating current voltage) can be taken out, and as a result, compared with the case where a constant voltage (direct current voltage) is taken out and converted with a DC-DC converter, excellently efficient boosting of voltage and storage of electricity can be achieved.

Particularly, in such a power-generating system 1, power generation efficiency can be improved.

Thus, in such a power-generating system 1, a first device 3 composed of a matrix that is capable of polarization, and a dispersion material having a specific heat capacity that is lower than the specific heat capacity of the matrix is used, and therefore compared with the case where a device that is capable of polarization is simply used as the first device 3, electricity can be generated with excellent efficiency.

Although not shown in detail, in application, the first device 3 can be stacked, as shown in FIG. 2, and furthermore, as shown in FIG. 3, the first device 3 can also be arranged in line on the same plane depending on the types, necessity, and application.

When the first device 3 is stacked and/or arranged in line on the same plane in its application, polarization can be caused in a plurality of first devices 3 simultaneously, and the first devices 3 can be electrically connected in series, and as a result, a high net generating power can be taken out compared with the case where the first device 3 is used singly.

In the description above, the first device 3 is disposed around (outer wall) the branch pipe 18, but the first device 3 is preferably disposed inside (e.g., inner wall) the branch pipe 18 so as to conduct the temperature change to the first device 3 without averaging the temperature.

EXAMPLES

In the following, examples suitable for the present invention are described.

<First Embodiment>

EXAMPLE 1

A bulk piezoelectric element (Composition: Nb and Sn added PZT (Nb/Sn/Pb (Zr,Ti) $O_3$), Curie temperature 315°C, relative dielectric constant: about 2500, product number: H5C, manufactured by Sumitomo Metal (SMI) Electronics Devices Inc.) was cut into a size of 25 mm × 25 mm × 1.2 mm, and a silver paste was applied on the front face and the reverse face thereof to be a size of 20 mm × 20 mm × 0.1 mm, thereby forming a silver electrode.

Then, the obtained piezoelectric element and silver electrode were heat-treated in an electric furnace at 300°C for 1 hour, thereby producing a sample.

Thereafter, using an aluminum tape of 20 mm × 20 mm, one side of the two lead wires (lead) was attached onto the silver electrodes, and the other side thereof was connected to a digital multimeter.

A heat gun was used as the heat source, and the heat gun and the piezoelectric element were positioned so that the jet was directed to the piezoelectric element and the jet was distant from the piezoelectric element by 5 cm.

By blowing hot air from the heat gun, and switching ON/OFF the heat gun over time, the temporal temperature variation of the heat gun and hot air was obtained. This temperature change caused the temperature of the piezoelectric element to change over time and polarization was caused, and the generated voltage (net generating power) was taken out via the electrode and the lead wire.

The temperature of the piezoelectric element was measured with an infrared thermometer, and the temperature of the hot air was adjusted so that the temperature include at least partially the range of 295°C (-20°C relative to the Curie temperature) to 325°C (+10°C relative to the Curie temperature) and that the temperature difference was about 30°C. The heating/cooling was switched at heating/cooling = 5s/10s cycle.

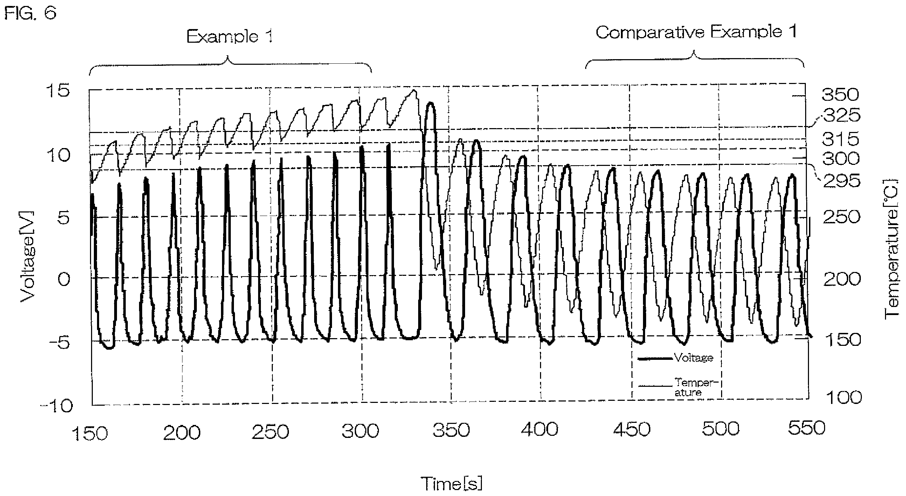

Then the voltage change of the net generating power taken out from the piezoelectric element was observed with the voltmeter. The relationship between the generated voltage and the temperature change is shown in FIG. 6.

Comparative Example 1

Continued from Example 1, the temporal temperature variation of the piezoelectric element was obtained and polarization was caused, and the generated voltage (net generating power) was taken out via the electrode and the lead wire.

In the heating with the heat gun and the cooling, the temperature of the piezoelectric element was measured with an infrared thermometer, and the temperature of the hot air was adjusted so that the temperature does not include the range of 295°C (-20°C relative to the Curie temperature) to 325°C (+10°C relative to the Curie temperature), and so that the temperature difference was about 150°C.

The heating/cooling was switched at heating/cooling = 12.5s/12.5s cycle.

Then, the voltage change of the net generating power taken out from the piezoelectric element was observed with the voltmeter. The relationship between the generated voltage and the temperature change is shown in FIG. 6.

(Examination)

It was confirmed that in Example 1, in which the temporal temperature variation of the piezoelectric element is obtained so as to include at least partially a temperature range of -20°C relative to the Curie temperature to +10°C relative to the Curie temperature, even with a slight temperature difference of about 30°C, power generation was achieved with excellent efficiency of about the same level with the case of Comparative Example 1, in which the temporal temperature variation is obtained so as not to include the above-described temperature range and the temperature difference was about 150°C.

EXAMPLE 2

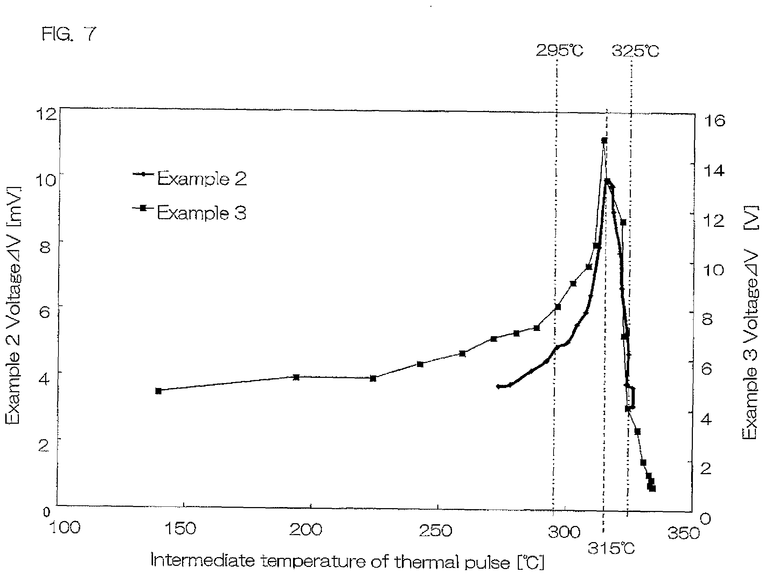

A sample was produced in the same manner as in Example 1, and in the same manner as in Example 1, the temporal temperature variation of the piezoelectric element of the sample was obtained and polarization was caused, and the generated voltage (net generating power) was taken out via the electrode and the lead wire.
In the heating with the heat gun and in the cooling, the temperature of the hot air and the blowing cycle were adjusted so that the intermediate temperature between the high-temperature state temperature and the low-temperature state temperature of the piezoelectric element changes in the range of 140 to 335°C. The temperature difference of the piezoelectric element was set to 30°C.
Then the voltage change of the net generating power taken out from the piezoelectric element was observed with the voltmeter. The relationship between the generated voltage and the temperature change is shown in FIG. 7.

EXAMPLE 3

Without heat-treating the piezoelectric element, in the same manner as in Example 2, the temporal temperature variation of the piezoelectric element of the sample was obtained and polarization was caused, and the generated voltage (net generating power) was taken out via the electrode and the lead wire.
Then, the voltage change of the net generating power taken out from the piezoelectric element was observed with the voltmeter. The relationship between the generated voltage and the temperature change is shown in FIG. 7.

(Examination)

In any of the heat-treated piezoelectric element and the piezoelectric element without the heat treatment, it was confirmed that power can be generated with excellent efficiency when the intermediate temperature of the high-temperature state temperature and the low-temperature state temperature is in the range of 295°C (-20°C of the Curie temperature) to 325°C (to +10°C relative to the Curie temperature).
It was confirmed that when the intermediate temperature of the high-temperature state temperature and the low-temperature state temperature is around 315°C (Curie temperature), particularly excellent power generation efficiency can be obtained.
On the other hand, it was confirmed that power generation performance is reduced when the intermediate temperature of the high-temperature state temperature and the low-temperature state temperature is higher than 325°C (+10°C relative to the Curie temperature). This is probably because decrease in poling effects.

<Second Embodiment>

EXAMPLE 4

50g of aluminum oxide ($Al_2O_3$, average particle size (measured with scanning electron microscope) 0.5 $\mu$m) powder, and 12g of platinum oxide ($PtO_2$, average particle size (measured with scanning electron microscope) 2 nm) powder were weighed, and they were mixed by using a ball mill.
Then, the obtained mixture powder was put into a mold of 25 mm $\times$ 25 mm $\times$ 1.2 mm, and pressure molded under 30MPa, and thereafter sintered at 1400°C for 2 hours, thereby producing a composite element.
Then, the silver paste was applied on the front face and on the reverse face of the obtained composite element to give a size of 20 mm $\times$ 20 rmn $\times$ 0.1 mm, thereby forming a silver electrode.
Then, the obtained composite element and silver electrode were heat-treated in a normal pressure sintering furnace at 400°C for 2 hours, thereby producing a sample.
Thereafter, using an aluminum tape of 20 mm $\times$ 20 mm, one side of the two lead wires (leads) was attached onto the silver electrodes, and the other side thereof was connected to a digital multimeter.
A heat gun was used as the heat source, and the heat gun and the composite element were positioned so that the jet was directed to the composite element and the jet was distant from the composite element by 5cm.
By blowing hot air from the heat gun, and switching ON/OFF the heat gun over time, the temporal temperature variation of the heat gun and hot air was obtained. This temperature change caused the temporal temperature variation of the composite element and polarization was caused, and the generated voltage (net generating power) was taken out via the electrode and the lead wire.
The temperature variation of the composite element was measured with an infrared thermometer, and the temperature of the hot air was adjusted so that the temperature was 270°C to 380°C.

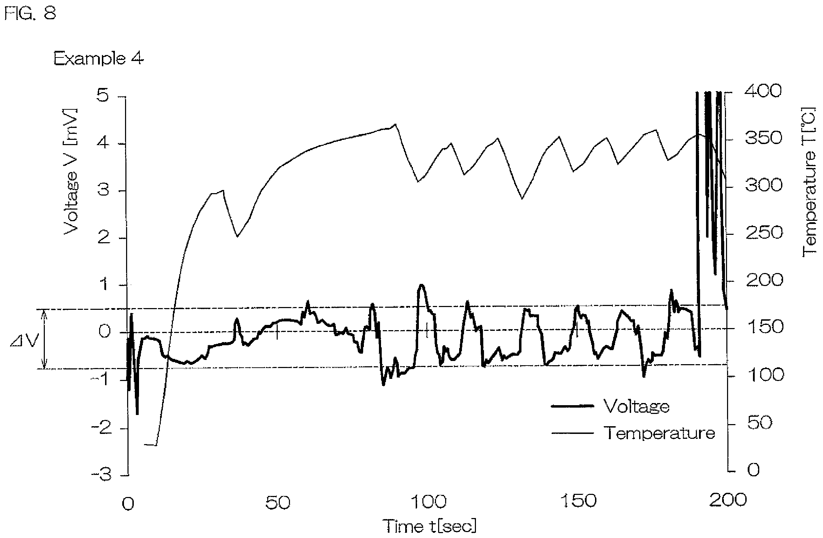

Then, the voltage change of the net generating power taken out from the composite element was observed with the voltmeter. The relationship between the generated voltage and the temperature change is shown in FIG. 8.

EXAMPLE 5

The temporal temperature variation of the composite element was obtained and polarization was caused, and the generated voltage (net generating power) was taken out via the electrode and the lead wire in the same manner as in Example 4, except that 40g of aluminum oxide ($Al_2O_3$, average particle size (measured with scanning electron microscope) 0.5 $\mu$m) powder, and 7.8g of copper oxide (CuO, average particle size (measured with scanning electron microscope) 1.5 nm) powder were mixed.

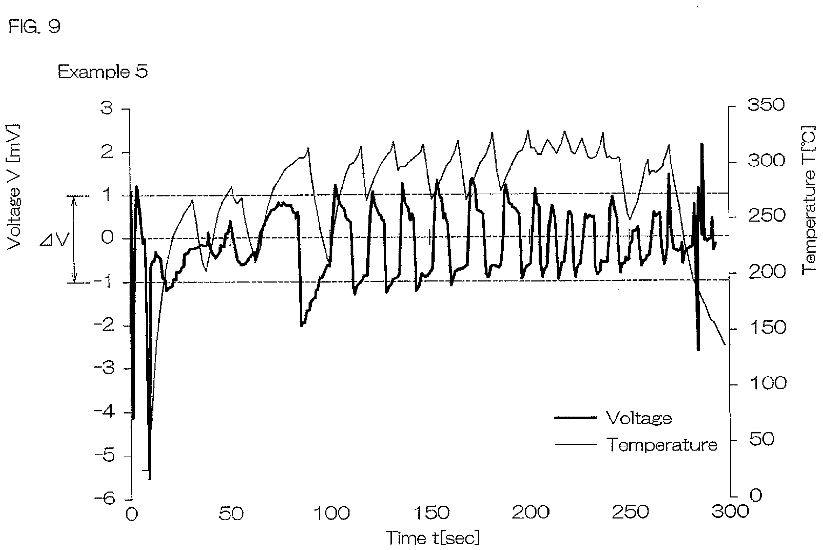

Then, the voltage change of the net generating power taken out from the composite element was observed with the voltmeter. The relationship between the generated voltage and the temperature change is shown in FIG. 9.

Comparative Example 2

The temporal temperature variation of the element was obtained and polarization was caused, and the generated voltage (net generating power) was taken out via the electrode and the lead wire in the same manner as in Example 4, except that the platinum oxide powder was not mixed.

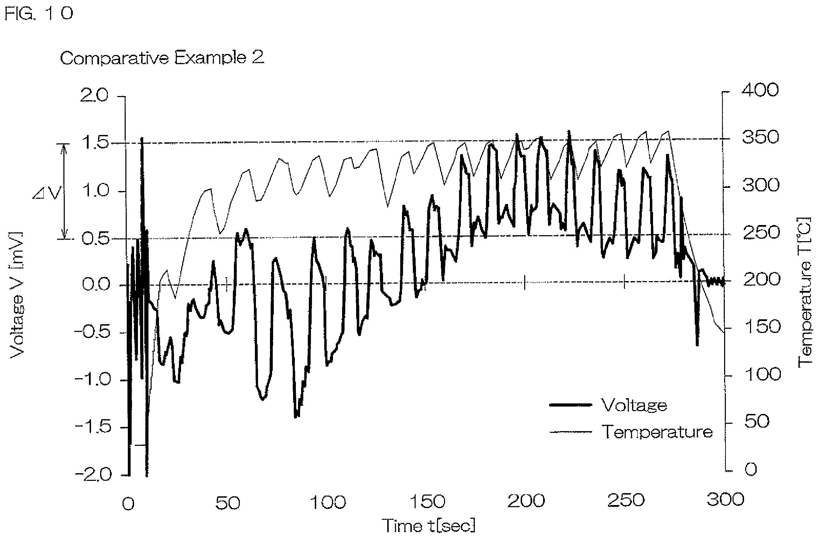

Then, the voltage change of the net generating power taken out from the element was observed with the voltmeter. The relationship between the generated voltage and the temperature change is shown in FIG. 10.

(Examination)

The difference ($\Delta V$) of the generated voltage by the composite element of Example 4 was about 1.3 V (ref: FIG. 8), and the difference ($\Delta V$) of the generated voltage by the composite element of Example 5 was about 2.0 V (ref: FIG. 9).

On the other hand, the difference ($\Delta V$) of the generated voltage by the element of Comparative Example 2 was about 1.0 V, which is lower than the difference ($\Delta V$) in Examples (ref: FIG. 10).

The results confirmed that use of a composite element composed of a matrix that is capable of polarization and a dispersion material having a specific heat capacity that is lower than the specific heat capacity of the matrix allows for excellently efficient power generation compared with the case where an element that is capable of polarization is just used.

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

Industrial Applicability

A power-generating system of the present invention is suitably used in internal combustion engines including an automobiles engine.

**Claims**

1. A power-generating system comprising:

   a heat source (2) which is able to produce temporal temperature variation;
   a first device (3) which is configured to produce temporal temperature variation so as to include at least partially a temperature range of -20°C relative to the Curie temperature to +10°C relative to the Curie temperature based on the temperature change of the heat source, and in which polarization occurs; and
   a second device (4) for taking out a net generating power from the first device,
   **characterized in that** the heat source (2) is an exhaust gas pipe (18) of an internal combustion engine (11) in which an intake stroke, a compression stroke, a power stroke, and an exhaust stroke are sequentially performed to increase the temperature in the exhaust stroke and decrease the temperature in the intake stroke, the compression stroke and the power stroke.

2. The power-generating system according to Claim 1, wherein the first device (3) changes its temperature so as to include its Curie temperature.

3. The power-generating system according to claim 1, wherein :

   the first device (3) is further comprising

      a matrix (3) that is capable of polarization and
      a dispersion material (3) having a specific heat capacity that is lower than the specific heat capacity of the matrix,
      in which polarization occurs based on the temperature change of the heat source.

**Patentansprüche**

1. Stromerzeugendes System, umfassend:

   eine Wärmequelle (2), der es möglich ist, eine zeitliche Temperaturschwankung zu erzeugen; eine erste Vorrichtung (3), die konfiguriert ist, um eine zeitliche Temperaturschwankung zu erzeugen, um zumindest teilweise einen Temperaturbereich von -20°C relativ zu der Curie-Temperatur bis zu +10°C relativ zu der Curie-Temperatur zu umfassen, basierend auf der Temperaturänderung der Wärmequelle, und in der eine Polarisation auftritt; und eine zweite Vorrichtung (4) für ein Ableiten von einem netzerzeugendem Strom von der ersten Vorrichtung, **dadurch gekennzeichnet, dass** die Wärmequelle (2) ein Abgasrohr (18) eines Verbrennungsmotors (11) ist, in dem ein Einlasshub, ein Kompressionshub, ein Krafthub und ein Auslasshub nacheinander durchgeführt werden, um die Temperatur in dem Auslasshub zu erhöhen und die Temperatur in dem Einlasshub, dem Kompressionshub und dem Krafthub zu senken.

2. Stromerzeugendes System nach Anspruch 1, wobei die erste Vorrichtung (3) ihre Temperatur verändert, um ihre Curie-Temperatur zu umfassen.

3. Stromerzeugendes System nach Anspruch 1, wobei:

   die erste Vorrichtung (3) ferner Folgendes umfasst:

   eine Matrix (3), der eine Polarisation möglich ist, und ein Dispersionsmaterial (3) mit einer spezifischen Wärmekapazität, die niedriger ist als die spezifische Wärmekapazität der Matrix, in dem eine Polarisation auftritt, basierend auf der Temperaturänderung der Wärmequelle.

**Revendications**

1. Système générateur d'énergie, comprenant :

   une source de chaleur (2) qui est capable de produire une variation de température temporelle ; un premier dispositif (3) qui est configuré pour produire une variation de température temporelle afin d'inclure au moins partiellement une plage de température de -20°C, relativement à la température de Curie, à +10°C, relativement à la température de Curie, en fonction du changement de température de la source de chaleur, et dans lequel une polarisation se produit ; et un second dispositif (4) pour extraire une énergie de génération nette à partir du premier dispositif, **caractérisé en ce que** la source de chaleur (2) est un tuyau de gaz d'échappement (18) d'un moteur à combustion interne (11) dans lequel une course d'admission, une course de compression, une course de combustion, et une course d'échappement sont séquentiellement réalisées pour augmenter la température dans la course d'échappement et réduire la température dans la course d'admission, la course de compression et la course de combustion.

2. Système générateur d'énergie selon la revendication 1, dans lequel le premier dispositif (3) change sa température afin d'inclure sa température de Curie.

3. Système générateur d'énergie selon la revendication 1, dans lequel :

   le premier dispositif (3) comprend en outre

   une matrice (3) qui est capable de polarisation et un matériau de dispersion (3) possédant une capacité thermique

   massive qui est inférieure à la capacité thermique massive de la matrice, dans lequel une polarisation se produit en fonction du changement de température de la source de chaleur.

FIG. 1

```
┌─────────────────────────────────────┐
│            Battery 7                 │
└─────────────────────────────────────┘
                  │
┌─────────────────────────────────────┐
│ Alternating current/direct current  │
│ converter (AC-DC converter) 6        │
└─────────────────────────────────────┘
                  │
┌─────────────────────────────────────┐
│            Booster 5                 │
└─────────────────────────────────────┘
                  │
   ┌ ─ ─ ─ ─ ─ ─ ─┼─ ─ ─ ─ ─ ─ ─ ─ ┐
   │  ┌─────────────────────────┐    │
   │  │    Second device 4      │    │
   │  └─────────────────────────┘    │
   │              │                  │
   │  ┌─────────────────────────┐    │
   │  │     First device 3      │    │
   │  ├─────────────────────────┤    │
   │  │     Heat source 2       │    │
   │  └─────────────────────────┘    │
   │                                 │
   │            Power-               │
   └ ─ ─ ─ ─ ─ generating ─ ─ ─ ─ ─ ─┘
                system 1
```

FIG. 2

FIG.3
(a)

(b)

FIG. 4

FIG. 5

FIG. 6

EP 2 752 984 B1

FIG. 7

FIG. 8

Example 4

FIG. 9

Example 5

EP 2 752 984 B1

FIG. 10

Comparative Example 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11332266 B
- US 3149246 A
- US 2010289377 A1
- US 2004251690 A1

**Non-patent literature cited in the description**

- **KANDILIAN et al.** *Smart Materials and Structures,* 2011, vol. 20, 055020